# FASCICULE DE BREVET EUROPEEN

(11) **EP 0 685 571 B1**
(45) Date de publication et mention de la délivrance du brevet: **16.12.1998**
(21) Numéro de dépôt: 95870065.0
(22) Date de dépôt: 02.06.1995
(51) Int. Cl.: C23C 14/34, C23C 14/56

(54) **Procédé et dispositif pour la formation d'un revêtement sur un substrat par pulvérisation cathodique**
Verfahren und Vorrichtung zur Beschichtung eines Substrats mittels Kathodenzerstäubung
Method and apparatus for coating a substrate by sputtering

(30) Priorité: 02.06.1994 BE 9400552
(43) Date de publication de la demande: 06.12.1995
(73) Titulaire: RECHERCHE ET DEVELOPPEMENT DU GROUPE COCKERILL SAMBRE, en abrégé: RD-CS, 4000 Liège (BE)
(72) Inventeur: Vanden Brande, Pierre (U.L.B.), B-1040 Bruxelles (BE); Lucas, Stéphane (U.L.B.), B-5020 Suarlée (BE); Winand, René (U.L.B.), B-1330 Rixensart (BE); Weymeersch, Alain (RD-CS), B-1300 Wavre (BE); Renard, Lucien (RD-CS), B-4100 Seraing (BE)
(74) Mandataire: Callewaert, Jean

(56) Documents cités:
- DE-A- 2 528 108
- PATENT ABSTRACTS OF JAPAN vol. 013 no. 302 (C-616) ,12 Juillet 1989 & JP-A-01 092384 (HITACHI LTD) 11 Avril 1989,
- PATENT ABSTRACTS OF JAPAN vol. 014 no. 149 (C-0705) ,22 Mars 1990 & JP-A-02 019466 (MATSUSHITA ELECTRIC IND CO LTD) 23 Janvier 1990,

## Description

La présente invention est relative à procédé pour la formation d'un revêtement sur un substrat par pulvérisation cathodique ("sputtering") dans une enceinte en présence d'un gaz ionisé, tel que défini dans le préambule de la revendication 1. Un tel procédé est notamment connu par le document DE-A-2.528.108.

Généralement les procédés utilisés actuellement pour la formation d'un revêtement d'une certaine épaisseur sur un support sont basés sur la technique de l'électrolyse en solution aqueuse ou sur la technique de la trempe dans un bain de métal fondu.

La technique de l'électrolyse implique l'utilisation de réactifs chimiques organiques et inorganiques dont les effluents doivent faire l'objet d'un traitement de neutralisation avant rejet.

Pour ce qui concerne la technique de trempe, celle-ci nécessite une énergie non négligeable pour maintenir le métal à l'état fondu. De plus. il n'est généralement pas possible de former, par cette technique, des dépôts légers et réguliers.

Un des buts essentiels de la présente invention est de remédier à ces inconvénients non négligeables des procédés connus et surtout de permettre de former des dépôts légers et compacts non poreux et très adhérents d'une certaine épaisseur avec un rendement industriellement valable. pouvant. de plus. être réalisé sans échauffement excessif du support à recouvrir, permettant ainsi de conserver toutes les propriétés initiales de ce dernier.

A cet effet, suivant l'invention, on contrôle le transfert thermique vers la couche superficielle de la cible par une régulation du refroidissement de cette couche au moyen d'une substance liquide conductrice intercalée entre un système de refroidissement et la couche superficielle de la cible.

Il s'agit notamment d'un procédé qui se distingue par rapport au procédé de pulvérisation cathodique classique par le fait que, au moyen d'un système de régulation de température, la couche superficielle de la cible est portée au-dessus de sa température de fusion pour la rendre liquide lors de l'alimentation des éléments à pulvériser ou après cette alimentation au moins pendant un temps suffisamment long pour permettre de réaliser cette répartition suffisamment uniforme.

Avantageusement, on fait usage d'une couche superficielle formée d'au moins un métal possédant une tension de vapeur inférieure à la pression régnant dans l'enceinte susdite.

Suivant une forme de réalisation particulière de l'invention, on fait usage d'une couche superficielle formée d'au moins un métal possédant une tension de vapeur inférieure à 10⁻³ Torr et de préférence inférieure à 10⁻⁵ Torr. tel qu'un des éléments suivants : Al, In, Bi, Li, Sn, Ga, Pb. Tl. Na. K. Rb et Fr et/ou au moins un alliage de ces éléments (1 Torr = 133 Pa).

L'invention concerne également un dispositif pour la mise en oeuvre du procédé précité tel que défini dans le préambule de la revendication 9.

Ce procédé est caractérisé par le fait que des moyens sont prévus comprenant un système de régulation thermique au moyen d'une substance liquide thermoconductrice intercalée entre un système de refroidissement et la couche superficielle de la cible, un système de chauffage pouvant éventuellement être incorporé entre la couche superficielle et le système de régulation de transfert thermique.

Suivant une forme de réalisation préférentielle de l'invention, on contrôle le transfert thermique vers la couche superficielle de la cible par une régulation du chauffage et du refroidissement de cette couche.

L'invention concerne également un dispositif pour la mise en oeuvre du procédé précité.

Ce procédé est caractérisé par le fait que des moyens sont prévus pour alimenter la couche superficielle de la cible par les éléments à déposer sur le substrat et pour maintenir ou porter cette couche superficielle à l'état liquide, de manière à permettre une répartition des éléments alimentés sur la surface de la cible.

Suivant une forme de réalisation préférée de l'invention, le substrat se présente sous forme d'une bande continue se déplaçant à travers au moins une enceinte dans laquelle est agencée une cible et dans laquelle a lieu la pulvérisation cathodique à partir de cette cible.

D'autres détails et particularités de l'invention ressortiront de la description donnée ci-après, à titre d'exemple non limitatif, d'une forme de réalisation particulière du procédé et du dispositif suivant l'invention, avec référence aux dessins annexés.

La figure 1 est une vue schématique en élévation d'une partie de cette forme de réalisation particulière du dispositif suivant l'invention.

La figure 2 est, à plus grande échelle, une vue entièrement schématique d'un détail de cette forme de réalisation.

La figure 3 est une vue schématique d'ensemble de cette forme de réalisation particulière.

Dans les différentes figures les mêmes chiffres de référence concernent des éléments identiques.

L'invention concerne tout d'abord un procédé pour la formation d'un revêtement sur un substrat par pulvérisation cathodique ("Sputtering") dans une enceinte maintenue à une pression relativement basse, en présence d'un gaz ionisé, suivant lequel on fait usage d'une cible présentant une couche superficielle orientée vers le substrat contenant au moins un des éléments du revêtement.

Il s'agit d'un procédé qui est particulièrement applicable pour la pulvérisation de métaux purs ou alliages métalliques, possédant, en phase liquide, une tension de vapeur inférieure à la pression régnant dans l'enceinte en cours de dépôt, soit en général inférieure à 10⁻³ Torr et de préférence inférieure à 10⁻⁵ Torr.

Avantageusement, la couche superficielle de la cible est formée par au moins un des éléments suivants : Al, In, Bi, Li, Sn, Ga, Pb, Tl, Na, K, Rb et Fr et/ou par au moins un alliage des métaux susdits.

Ci-après est donné un tableau reprenant les métaux qui conviennent particulièrement pour le procédé suivant l'invention.

| METAL | T.FUSION. °C | T.VAPEUR-Torr | REND.PULV.% |
|---|---|---|---|
| Al | 660 | <10⁻⁵ | 1.05 |
| Pb | 327 | <10⁻⁵ | 2.7 |
| Bi | 271 | <10⁻⁵ | 6.64 |
| Sn | 231,9 | <10⁻⁵ | 1.2(s) 1.4(1) |

Les rendements de pulvérisation sont donnés dans ce tableau pour un bombardement de la cible par des ions d'argon ayant une énergie cinétique de 500eV. Les valeurs obtenues pour l'étain proviennent de la référence suivante : R.C.KRUTENAT and C.PANZERA J.Appl.Phys. 41(1970)4953. L'étain est particulièrement intéressant car sa tension de vapeur est inférieure à 10⁻¹¹ Torr à 530°C. Par suite de cette basse tension de vapeur on évite tout problème de contamination des parois de l'enceinte par ce métal en dessous de cette température, même lorsqu'un très haut vide règne dans cette enceinte.

Plus particulièrement, l'on contrôle le transfert thermique vers la couche superficielle de la cible par une régulation du refroidissement de la cible et éventuellement par l'utilisation de moyens de chauffage, de manière à maintenir ou à porter la couche superficielle du métal ou de l'alliage métallique à pulvériser à l'état liquide, ceci dans le but principal de pouvoir alimenter cette couche en métal et alliage d'apport au cours de la pulvérisation. Ainsi, on peut éviter les arrêts pour changer la cible et maintenir l'épaisseur de celle-ci sensiblement constante, lors de la pulvérisation, et aussi mince que possible. De cette façon, on obtient un transfert thermique très efficace avec une consommation très réduite en énergie.

L'alimentation en métal de la couche superficielle de la cible a lieu par addition d'un métal d'apport soit à l'état fondu soit sous une forme solide telle qu'il fond au contact de cette couche superficielle maintenue au-dessus de la température de fusion du métal, mais inférieure à la température d'ébullition de ce dernier dans les conditions de travail.

L'épaisseur de la couche superficielle à la cible est de préférence maintenue entre 0,01 et 0,5 cm.

Certaines précisions supplémentaires de cette forme de réalisation particulières du procédé, suivant l'invention, seront données ci-après lors de la description de la forme de réalisation particulière du dispositif de pulvérisation cathodique pouvant être utilisé pour la mise en oeuvre de ce procédé.

Ce dispositif se caractérise tout particulièrement par le fait qu'il comprend des moyens pour porter et maintenir la couche superficielle susdite de la cible à l'état liquide et de réguler sa température.

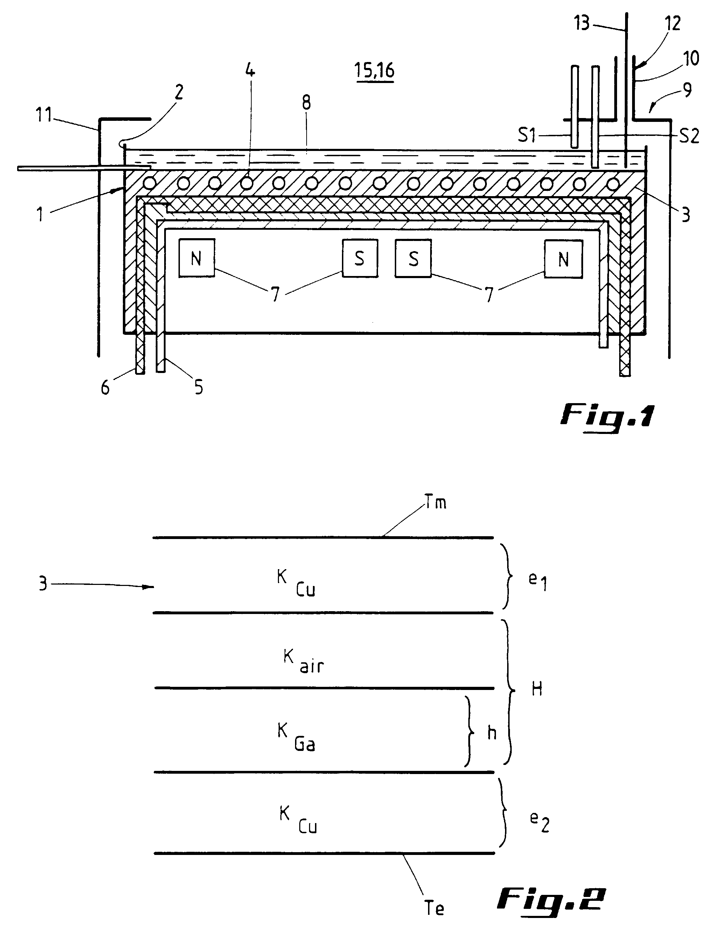

A cet égard, comme illustré par la figure 1, la cible 1 de ce dispositif comprend un bac de rétention 2 dont le fond 3 est formé d'un bloc d'une matière thermoconductrice, tel que du cuivre ou un autre métal présentant de bonnes propriétés thermoconductrices, dans lequel sont incorporés un système de chauffage 4, par exemple par résistance électrique, et un système de refroidissement 5, par exemple par eau, entre lesquels se situe un système de régulation de transfert thermique 6 comprenant un circuit pour un fluide thermoconducteur. Il y a, toutefois, lieu de noter que le système de chauffage 4 n'est pas indispensable au bon fonctionnement étant donné que la majeure partie de la chaleur nécessaire pour fondre la couche superficielle proviendra du plasma. Enfin, en dessous de ce bloc en cuivre 3 se trouvent les aimants 7 d'un magnétron conventionnel généralement utilisé dans un dispositif de pulvérisation cathodique.

Le bac de rétention 2 est destiné à maintenir une couche superficielle 8 relativement mince du métal de pulvérisation à l'état liquide. L'épaisseur de cette couche est généralement maintenue entre 0,01 et 0,5 cm et est de préférence de l'ordre de 1 mm.

Le système de chauffage 4, éventuellement présent, se situe aussi près que possible de cette couche superficielle, de manière à permettre ainsi un transfert thermique aussi efficace que possible vers cette dernière.

Le système de régulation 6 interposé, entre le système de chauffage 4 et le système de refroidissement 5, comprend une fente dans laquelle peut être introduit le fluide thermoconducteur. Ce dernier est de préférence constitué par un métal liquide, notamment du gallium.

Ainsi, si on désire abaisser la température de la couche superficielle 8 du métal liquide, on introduit ce fluide conducteur dans la fente entre les systèmes de chauffage et de refroidissement, de manière à permettre de réaliser une évacuation thermique vers le système de refroidissement.

Par contre, si on désire augmenter la température de la couche superficielle du métal liquide 8, l'on élimine le fluide thermoconducteur entre le système de chauffage et le système de refroidissement, de manière à créer ainsi dans la fente entre ces deux systèmes une couche isolante d'air.

La figure 2 illustre de façon plus concrète cette régulation du transfert thermique entre le métal liquide 8 contenu dans le bac de rétention 2 et le système de refroidissement 5.

Dans cette figure très schématique, Tm indique la température de la couche superficielle 8 ou du fond du bac de rétention 2, e1 indique l'épaisseur de la couche du bloc de matière conductrice contenant le système de chauffage 4 éventuel. Cette couche de matière conductrice est alors suivie d'un espace d'une épaisseur H, formant la fente précitée, dans lequel peut être introduit le fluide thermoconducteur. Dans cette figure, h indique l'épaisseur de la couche de fluide thermoconducteur. Enfin, une nouvelle couche du bloc de matière thermoconductrice solide d'une épaisseur e2 sépare le fluide thermoconducteur du système de refroidissement 5, dont Te représente la température.

Le niveau du métal liquide 8 dans le bac de rétention 2 est contrôlé dans cette forme de réalisation particulière de l'invention au moyen de deux sondes S1 et S2 fonctionnant par comparaison de la tension mesurée avec la tension de la cible.

Lorsque le niveau bas est atteint, la cible 1 est alimentée en métal de pulvérisation 13, tandis que lorsque le niveau haut est atteint, cette alimentation est arrêtée.

Ainsi, la sonde S1 mesure le niveau maximum, tandis que la sonde S2 mesure le niveau minimum de la couche de métal liquide 8.

Lors de cette alimentation, le métal constituant la couche superficielle 8 est porté ou maintenu au-dessus de sa température de fusion et le contrôle de cette température s'effectue au moyen d'une sonde S3. Un chauffage d'appoint peut éventuellement être prévu à proximité de la zone d'alimentation 9 pour atteindre la température de fusion ainsi que pour compenser la chaleur latente de fusion du métal.

Dans certains cas, la couche superficielle 8 peut être à l'état solide lors de la pulvérisation et n'est fondue que pour permettre l'alimentation de celle-ci ou pour permettre de supprimer les inégalités d'épaisseur de cette couche provoquée par la pulvérisation à l'état solide.

De plus, la zone d'alimentation est avantageusement blindée par une gaine métallique 10 suffisamment proche autour du métal de pulvérisation 13 introduit dans la couche de métal liquide 8, pour y éviter la formation d'un plasma. Une gaine analogue 11 est avantageusement également prévue tout autour du bord du bac de rétention 2.

Dans cette forme de réalisation du dispositif de pulvérisation cathodique, un mécanisme d'alimentation particulier 12 est prévu pour l'alimentation de la couche superficielle 8 de la cible 1 par du métal de pulvérisation 13 lorsque le niveau de cette couche descend en dessous d'une limite déterminée, c'est-à-dire atteint la sonde S2.

Ce mécanisme comprend un dévidoir, non représenté aux figures, d'un fil de métal de pulvérisation 13 guidé dans un tube de blindage 10, vers la couche superficielle de métal liquide 8 de la cible 1 pour ainsi être fondu au fur et à mesure qu'il entre dans cette couche.

Le mécanisme d'alimentation 12 est isolé électriquement par rapport à la masse puisqu'il est au potentiel de la cible 1.

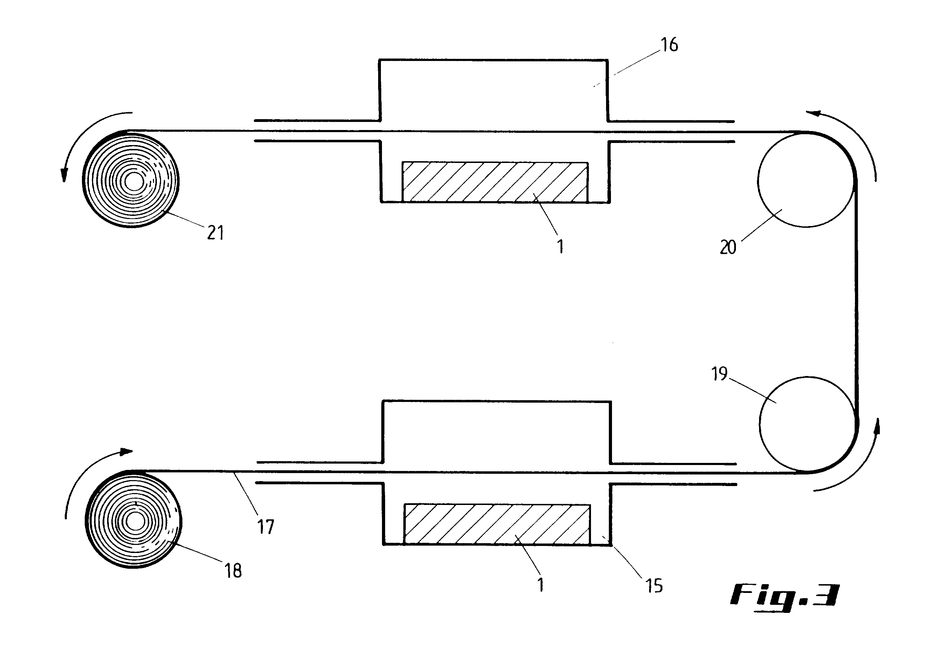

La figure 3 montre schématiquement une forme de réalisation du dispositif de pulvérisation cathodique suivant l'invention pouvant convenir pour le revêtement en continu ou au défilé d'une bande sur ses deux faces. Ce dispositif comprend deux enceintes successives de pulvérisation cathodique 15 et 16 dans lesquelles règne de préférence une pression comprise entre 10⁻³ et 5.10⁻² Torr pendant la pulvérisation.

Dans chacune de ces enceintes 15 et 16 est agencée une cible 1 du type de celle montrée à la figure 1, c'est-à-dire comprenant un bac de rétention 2 contenant du métal de pulvérisation 8 à l'état liquide.

Le substrat sur lequel un revêtement doit être déposé par pulvérisation cathodique est formé par une bande sans fin 17, telle qu'une tôle, se déplaçant successivement à travers l'enceinte 15 et l'enceinte 16, en regard des cibles respectives 1.

A cet effet, la tôle 17 à revêtir sur ses deux faces est déroulée à partir d'un dévidoir 18 pour traverser l'enceinte 15, où une de ses faces est revêtue par du métal de pulvérisation. Ensuite, elle passe dans l'enceinte 16, après avoir été guidée sur des tambours de renvoi 19 et 20, permettant d'inverser son sens de déplacement au moment où celle-ci entre dans cette enceinte 16 où a lieu le recouvrement de l'autre face par du métal de pulvérisation. Enfin, à la sortie de cette enceinte 16 la bande recouverte sur ses deux faces par du métal de pulvérisation est enroulée en bobine 21 pour le stockage.

Le procédé et le dispositif suivant l'invention conviennent particulièrement pour la formation de revêtements d'étain et d'aluminium sur des tôles d'acier.

En ce qui concerne l'étain, le procédé actuellement utilisé est basé sur la technique de l'électrolyse en solution aqueuse, tandis que le recouvrement d'aluminium est généralement obtenu par trempe de la tôle d'acier dans un bain de métal fondu. Les inconvénients de ces deux techniques ont déjà été décrits sommairement ci-dessus.

Les calculs montrent qu'une ligne d'étamage permettant un revêtement de 1 g/m² d'étain sur chaque face de la tôle, pour une vitesse de dépôt de 50 µm/min., correspondant à une densité de puissance estimée de 750 W/cm², nécessite une longueur utile de cible de 0,8 m pour une vitesse de défilement de la tôle de 300 m/min. et de 1,6 m pour une vitesse de défilement de 600 m/min. par face. Ce dimensionnement est donc tout à fait réaliste industriellement.

Par conséquent, en pratique, la vitesse de défilement d'une bande métallique à recouvrir sera avantageusement comprise entre 300 et 600 m/min. pour une vitesse de dépôt de 1 à 50 µm/min. et une densité de puissance à la cible de 15 à 750 W/cm².

Ci-après est donné un exemple concret de paramètres de fonctionnement du dispositif de pulvérisation cathodique suivant la forme de réalisation particulière représentée aux figures. Dans cet exemple le système de réalisation thermique utilise du gallium comme fluide thermoconducteur.

Basé sur la figure 2, ces paramètres se situent comme suit :
- température de circuit d'eau (°C) :: Te = 50 (température de fusion de gallium = 29,78°C)

Les différentes valeurs sont calculées pour les valeurs extrêmes de densité de puissance : 15W/cm² et 750W/cm²
- température interface Cu/Ga (°C) :: TCu/Ga
- température interface Ga/air (°C) :: TGa/air
- température interface air/Cu (°C) :: Tair/Cu
- température de surface Cu (°C) :: Tm
- épaisseur cuivre (cm) :: e = 0.5 (e=e₁=e₂)
- épaisseur circuit Ga (cm) :: H = 0.1
- hauteur du bain de Ga (cm) :: h = variable
- cond. therm. Cu (W/cmK) :: KCu = 4
- cond. therm. Ga (W/cmK) :: KGa = 0.3
- cond. therm. air (W/cmK) :: Kair = 0.00026

| Valeurs pour 15W/cm² | | | | |
|---|---|---|---|---|
| TCu/Ga | TGa/air | Tair/Cu | Tm | h |
| 50.375 | 55 | 58 | 60 | 0.0995 |
| 50.34 | 54.96 | 498 | 500 | 0.092 |
| 50.33 | 54.77 | 698.1 | 700 | 0.088 |

| Valeurs pour 750W/cm² | | | | |
|---|---|---|---|---|
| TCu/Ga | TGa/air | Tair/Cu | Tm | h |
| 68.75 | 318.74 | 326.25 | 420 | 0.1 |
| 68.74 | 318.67 | 406.2 | 500 | 0.0999 |
| 68.73 | 318.48 | 606.23 | 700 | 0.099 |

Il est bien entendu que l'invention n'est pas limitée à la forme de réalisation concrète du procédé et du dispositif de pulvérisation cathodique décrits ci-dessus et représenté aux figures annexées, mais que bien des variantes peuvent être envisagées sans sortir du cadre de la présente invention. C'est ainsi que, comme il résulte déjà de ce qui précède, la couche superficielle de la cible peut être maintenue constamment à l'état liquide durant toute la durée de la pulvérisation, ou, par contre, peut uniquement être portée dans un état fondu pendant et/ou éventuellement un certain temps après l'alimentation en métal d'apport vers cette couche et/ou encore lorsque des zones d'érosion d'une certaine profondeur se sont formées dans la couche superficielle solide en regard des aimants du magnétron.

## Revendications

1. Procédé pour la formation d'un revêtement sur un substrat (17) par pulvérisation cathodique dans une enceinte (15, 16) en présence d'un gaz ionisé, suivant lequel on fait usage d'une cible (1) présentant une couche superficielle (8) orientée vers le substrat (17) et contenant au moins un des éléments à déposer sur ce substrat (17) par pulvérisation cathodique, cette dernière étant réalisée dans des conditions telles que cet ou ces élément(s) puissent être éjecté(s) de la couche superficielle susdite sous l'effet du gaz ionisé pour ensuite se déposer sur le substrat (17), procédé suivant lequel on alimente la couche superficielle de la cible par les éléments à déposer sur le substrat et on maintient ou porte cette couche superficielle à l'état liquide, de manière à permettre une répartition, de préférence sensiblement uniforme. des éléments alimentés sur la surface de la cible (1), caractérisé en ce qu'on contrôle le transfert thermique vers la couche superficielle (8) de la cible (1) par une regulation du refroidissement de cette couche au moyen d'un circuit pour un fluide thermoconducteur (6) intercalée entre un système de refroidissement (5) et la couche superficielle (8) de la cible (1).

2. Procédé suivant la revendication 1, caractérisé en ce que l'on fait usage d'une couche superficielle (8) formée d'au moins un métal possédant une tension de vapeur inférieure à la pression régnant dans l'enceinte susdite (15, 16).

3. Procédé suivant l'une ou l'autre des revendications 1 et 2, caractérisé en ce que l'on fait usage d'une couche superficielle (8) formée d'au moins un métal possédant une tension de vapeur inférieure à 10⁻³ Torr et de préférence inférieure à 10⁻⁵ Torr.

4. Procédé suivant l'une quelconque des revendications 1 à 3, caractérisé en ce que la couche superficielle (8) de la cible (1) est formée d'au moins un des éléments suivants : Al, In, Bi, Li, Sn, Ga, Pb, Tl, Na, K, Rb et Fr et/ou par au moins un alliage des métaux susdits.

5. Procédé suivant l'une quelconque des revendications 1 à 4, caractérisé en ce que l'on maintient l'épaisseur de la couche superficielle (8) de la cible (1) en alimentant cette dernière d'un métal d'apport à l'état fondu ou pouvant fondre au contact de la couche superficielle (8) de la cible (1).

6. Procédé suivant l'une quelconque des revendications 1 à 5, caractérisé en ce que l'on maintient l'épaisseur de la couche superficielle (8) liquide de la cible (1) entre 0,01 et 0,5 cm.

7. Procédé suivant l'une quelconque des revendications 1 à 6, caractérisé en ce que l'on déplace le substrat précité (17) d'une manière sensiblement continue en égard de la couche superficielle (8) de la cible (1).

8. Procédé suivant l'une quelconque des revendications 1 à 7, caractérisé en ce que l'on maintient dans l'enceinte précitée (15, 16) une pression comprise entre 0,133 Pa et 0,667 Pa (10⁻³ et 5.10⁻² Torr) pendant la pulvérisation.

9. Dispositif pour la formation d'un revêtement sur un substrat (17) par pulvérisation cathodique comprenant au moins une enceinte (15, 16) dans laquelle se trouve ce substrat (17) et une cible (1) présentant une couche superficielle (8) orientée vers ce dernier contenant au moins un des éléments du revêtement. caractérisé en ce que des moyens (4, 5, 6) étant prévus pour alimenter la couche superficielle (8) de la cible (1) par les éléments à déposer sur le substrat (17) et pour maintenir ou porter cette couche superficielle (8) à l'état liquide, de manière à permettre une répartition des éléments alimentés sur la surface de la cible (1), caractérisé en ce que les moyens précités comprennent un système de régulation thermique (6) au moyen d'un circuit pour un fluide thermoconducteur intercalée entre un système de refroidissement (5) et la couche superficielle (8) de la cible (1), un système de chauffage (4) pouvant éventuellement être incorporé entre la couche superficielle (8) et le système de régulation de transfert thermique (6).

10. Dispositif suivant la revendication 9, caractérisé en ce qu'il comprend un réservoir de rétention (2) pour la cible (1) dont le fond (3) est réalisé en une matière thermoconductrice dans lequel sont incorporés, sous forme de couches superposées, le système de chauffage (4) éventuel, le système de refroidissement (5) et le système de régulation (6).

11. Dispositif suivant la revendication 10, caractérisé en ce que le système de chauffage (4) éventuel se situe à proximité de la cible (1).

12. Dispositif suivant l'une quelconque des revendications 9 à 11, caractérisé en ce que le système de régulation du transfert thermique (6) comprend un circuit de métal liquide, plus particulièrement de gallium, des moyens étant prévus pour évacuer ce métal de ce circuit lorsqu'un apport de calories est nécessaire et d'introduire ce métal dans ce circuit lorsqu'il y a lieu d'éliminer des calories de la cible (1).

13. Dispositif suivant l'une quelconque des revendications 9 à 12, caractérisé en ce qu'il comprend deux sondes (S₁ et S₂) pour la mesure du niveau de la couche liquide (8) de la cible (1), l'une (S₁) pour le niveau maximum, l'autre (S₂) pour le niveau minimum, chacune de ces sondes fonctionnant de préférence par comparaison de la tension mesurée avec la tension à la cible (1).

14. Dispositif suivant l'une quelconque des revendications 9 à 13, caractérisé en ce qu'il comprend un mécanisme (12) pour l'alimentation de la couche superficielle (8) de la cible (1) par du métal de pulvérisation lorsque l'épaisseur de cette dernière descend en dessous d'une limite prédéterminée.

15. Dispositif suivant l'une ou l'autre des revendications 13 et 14, caractérisé en ce qu'il comprend une sonde (S₃) pour la mesure et le contrôle de la température (Tₘ) de la couche superficielle (8) de la cible (1), cette sonde (S₃) permettant d'agir sur le système de régulation du transfert thermique (6) et d'amener la température (Tₘ) de la couche superficielle susdite (8) de la cible (1) au-dessus de sa température de fusion lors de l'alimentation de cette dernière par du métal à fondre.

16. Dispositif suivant l'une quelconque des revendications 9 à 15, caractérisé en ce que le substrat (17) se présente sous forme d'une bande continue se déplaçant à travers au moins une enceinte (15, 16) dans laquelle est agencée une cible (1).

17. Dispositif suivant la revendication 16, caractérisé en ce que, en vue de recouvrir les deux faces de la bande précitée (17), il comprend deux enceintes successives (15) et (16), dans une desquelles (15) la cible (1) est agencée d'un des côtés de la bande (17) et dans l'autre enceinte (16) du côté opposé de cette dernière.

## Patentansprüche

1. Verfahren zum Beschichten eines Substrates (17) mittels Kathodenzerstäubung in einer Kammer (15, 16) in Gegenwart eines ionisierten Gases,
wobei ein Target (1) verwendet wird, welches eine Oberflächenschicht (8) aufweist, die zum Substrat (17) hin orientiert ist und die mindestens eines der Elemente enthält, die auf dem Substrat (17) mittels Kathodenzerstäubung abgeschieden werden sollen,
welches unter solchen Bedingungen durchgeführt wird, daß das oder die Elemente unter dem Einfluß des ionisierten Gases aus der Oberflächenschicht herausgeschleudert werden können, um sich anschließend auf dem Substrat (17) niederzuschlagen,
und wobei während des Verfahrens der Oberflächenschicht des Targets die auf dem Substrat abzuscheidenden Elemente zugeführt werden und
wobei diese Oberflächenschicht im flüssigen Zustand gehalten oder dahin überführt wird, um derart eine vorzugsweise merklich gleichmäßige Verteilung der Elemente, die der Oberfläche des Targets (1) zugeführt werden, zu erreichen,
dadurch gekennzeichnet, daß
der Wärmetransfer zur Oberflächenschicht (8) des Targets (1) durch eine Regelung zur Kühlung dieser Schicht mittels eines Kreislaufes für ein wärmeleitfähiges Fluid (6) kontrolliert wird,
welcher zwischen einem Kühlsystem (5) und der Oberflächenschicht (8) des Targets (1) angeordnet ist.

2. Verfahren nach Anspruch 1, dadurch gekennzeichnet, daß eine Oberflächenschicht (8) verwendet wird, die aus mindestens einem Metall gebildet ist, welches einen niedrigeren Dampfdruck als der in der Kammer (15, 16) herrschende Druck aufweist.

3. Verfahren nach einem der Ansprüche 1 und 2, dadurch gekennzeichnet, daß eine Oberflächenschicht (8) verwendet wird, die aus mindestens einem Metall gebildet ist, welches einen Dampfdruck von weniger als 10⁻³ Torr und vorzugsweise weniger als 10⁻⁵ Torr aufweist.

4. Verfahren nach einem der Ansprüche 1 bis 3, dadurch gekennzeichnet, daß die Oberflächenschicht (8) des Targets (1) aus mindestens einem der folgenden Elemente besteht: Al, In, Bi, Li, Sn, Ga, Pb, Tl, Na, K, Rb und Fr und/oder aus mindestens einer Legierung der genannten Metalle.

5. Verfahren nach einem der Ansprüche 1 bis 4, dadurch gekennzeichnet, daß die Dicke der Oberflächenschicht (8) des Targets (1) derart aufrechterhalten wird, daß dieser zusätzliches Metall zugeführt wird, welches sich im schmelzflüssigen Zustand befindet oder welches bei Kontakt mit der Oberflächenschicht (8) des Targets (1) schmelzen kann.

6. Verfahren nach einem der Ansprüche 1 bis 5, dadurch gekennzeichnet, daß die Dicke der flüssigen Oberflächenschicht (8) des Targets (1) zwischen 0,01 und 0,5 cm gehalten wird.

7. Verfahren nach einem der Ansprüche 1 bis 6, dadurch gekennzeichnet, daß das Substrat (17) merklich stetig in Bezug auf die Oberflächenschicht (8) des Targets (1) verschoben wird.

8. Verfahren nach einem der Ansprüche 1 bis 7, dadurch gekennzeichnet, daß in der Kammer (15, 16) ein Druck zwischen 0,133 Pa und 0,667 Pa (10⁻³ und 5 x 10⁻² Torr) während der Zerstäubung aufrechterhalten wird.

9. Vorrichtung zur Beschichtung eines Substrates (17) mittels Kathodenzerstäubung, umfassend mindestens eine Kammer (15, 16), in welcher sich das Substrat (17) und ein Target (1) befinden, welches eine Oberflächenschicht (8) aufweist, die zum letzteren hin orientiert ist und die mindestens eines der Beschichtungselemente enthält,
dadurch gekennzeichnet, daß
Mittel (4, 5, 6) vorgesehen sind, um der Oberflächenschicht (8) des Targets (1) die auf das Substrat (17) abzuscheidenden Elemente zuzuführen und um diese Oberflächenschicht (8) in flüssigem Zustand zu erhalten oder zu überführen,
derart, daß eine Verteilung der zugeführten Elemente auf der Oberfläche des Targets (1) ermöglicht wird,
dadurch gekennzeichnet, daß die Mittel ein System zur Wärmeregelung (6) umfassen, welches aus
einem Kreislauf für ein wärmeleitfähiges Fluid besteht, der zwischen einem Kühlsystem (5) und der Oberflächenschicht (8) des Targets (1) angeordnet ist,
und einem Heizsystem (4), das eventuell zwischen der Oberflächenschicht (8) und dem Regelsystem für den wärmetransfer (6) eingefügt ist.

10. Vorrichtung nach Anspruch 9, dadurch gekennzeichnet, daß sie einen Rückhaltebehälter (2) für das Target (1) umfaßt, dessen Boden (3) in einem wärmeleitfähigen Material ausgeführt ist und in den in Form von übereinander angeordneten Schichten das eventuelle Heizsystem (4), das Kühlsystem (5) und das Regelsystem (6) eingebettet sind.

11. Vorrichtung nach Anspruch 10, dadurch gekennzeichnet, daß das eventuelle Heizsystem (4) in der Nähe des Targets (1) angeordnet ist.

12. Vorrichtung nach einem der Ansprüche 9 bis 11, dadurch gekennzeichnet, daß das System zur Regelung des Wärmetransfers (6) einen Kreislauf aus flüssigem Metall umfaßt, insbesondere aus Gallium, und Mittel vorgesehen sind, um das Metall aus diesem Kreislauf zu entfernen, wenn eine Zufuhr von Wärme erforderlich ist, und um Metall in den Kreislauf einzuspeisen, wenn Wärme vom Target (1) abgeführt werden muß.

13. Vorrichtung nach einem der Ansprüche 9 bis 12, dadurch gekennzeichnet,
daß sie zwei Meßfühler (S₁ und S₂) zum Messen der Höhe der flüssigen Schicht (8) des Targets (1) umfaßt,
der eine (S₁) für die maximale Höhe und der andere (S₂) für die minimale Höhe,
wobei jeder der Meßfühler vorzugsweise über den Vergleich der gemessenen Spannung mit der Spannung des Targets (1) arbeitet.

14. Vorrichtung nach einem der Ansprüche 9 bis 13, dadurch gekennzeichnet, daß sie einen Mechanismus (12) zur Beschickung der Oberflächenschicht (8) des Targets (1) mit dem zu zerstäubenden Metall umfaßt, sobald die Dicke der letzteren unterhalb eines vorher festgelegten Grenzwertes fällt.

15. Vorrichtung nach einem der Ansprüche 13 und 14, dadurch gekennzeichnet,
daß sie einen Meßfühler (S₃) zur Bestimmung und zur Kontrolle der Temperatur (Tₘ) der Oberflächenschicht (8) des Targets (1) umfaßt,
wobei dieser Meßfühler (S₃) es ermöglicht, auf das System zur Regelung des Wärmetransfers (6) einzuwirken und die Oberflächenschicht (8) des Targets (1) auf eine Temperatur (Tₘ) oberhalb ihrer Schmelztemperatur zu bringen während sie mit dem zu schmelzenden Metall beschickt wird.

16. Vorrichtung nach einem der Ansprüche 9 bis 15, dadurch gekennzeichnet, daß das Substrat (17) in Form eines Endlosstreifens vorliegt, der sich durch mindestens eine Kammer (15, 16), in welcher ein Target (1) angeordnet ist, bewegt.

17. Vorrichtung nach Anspruch 16, dadurch gekennzeichnet, daß sie zwei aufeinander folgende Kammern (15) und (16) umfaßt, um die beiden Seiten des Streifens (17) zu beschichten,
wobei in einer der Kammern (15) das Target (1) zu einer Seite des Streifens (17) und in der anderen Kammer (16) zu seiner entgegengesetzten Seite hin angeordnet ist.

## Claims

1. Process for the formation of a coating on a substrate (17) by sputtering in a chamber (15, 16) in the presence of an ionized gas, in which process use is made of a target (1) having a surface layer (8) facing the substrate (17) and containing at least one of the elements to be deposited on this substrate (17) by sputtering, the latter being carried out under conditions such that this element or these elements can be ejected from the abovementioned surface layer under the effect of the ionized gas in order subsequently to be deposited on the substrate (17), in which process the surface layer of the target is supplied with the elements to be deposited on the substrate and this surface layer is maintained in or brought to the liquid state, so as to allow distribution, preferably approximately uniform distribution, of the elements supplied on the surface of the target (1), characterized in that heat transfer to the surface layer (8) of the target (1) is controlled by regulating the cooling of this layer by means of a circuit for a thermally conductive fluid (6), inserted between a cooling system (5) and the surface layer (8) of the target (1).

2. Process according to Claim 1, characterized in that use is made of a surface layer (8) formed from at least one metal having a vapour pressure of less than the pressure prevailing in the abovementioned chamber (15, 16).

3. Process according to either of Claims 1 and 2, characterized in that use is made of a surface layer (8) formed from at least one metal having a vapour pressure of less than 10⁻³ torr and preferably of less than 10⁻⁵ torr.

4. Process according to any one of Claims 1 to 3, characterized in that the surface layer (8) of the target (1) is formed from at least one of the following elements: Al, In, Bi, Li, Sn, Ga, Pb, Tl, Na, K, Rb and Fr and/or by at least one alloy of the abovementioned metals.

5. Process according to any one of Claims 1 to 4, characterized in that the thickness of the surface layer (8) of the target (1) is maintained by supplying the latter with an addition metal which is in the molten state or is able to melt on contact with the surface layer (8) of the target (1).

6. Process according to any one of Claims 1 to 5, characterized in that the thickness of the liquid surface layer (8) of the target (1) is maintained between 0.01 and 0.5 cm.

7. Process according to any one of Claims 1 to 6, characterized in that the aforementioned substrate (17) is moved in a substantially continuous manner past the surface layer (8) of the target (1).

8. Process according to any one of Claims 1 to 7, characterized in that a pressure of between 0.133 Pa and 0.667 Pa (10⁻³ and 5x10⁻² torr) is maintained in the aforementioned chamber (15, 16) during sputtering.

9. Apparatus for the formation of a coating on a substrate (17) by sputtering, comprising at least one chamber (15, 16) in which this substrate (17) and a target (1) lie, the said target having a surface layer (8) facing the said substrate and containing at least one of the elements of the coating, means (4, 5, 6) being provided in order for the surface layer (8) of the target (1) to be supplied with the elements to be deposited on the substrate (17) and for this surface layer (8) to be maintained in or brought to the liquid state, so as to allow distribution of the elements supplied on the surface of the target (1), characterized in that the aforementioned means comprise a system (6) for heat regulation by means of a circuit for a thermally conductive fluid, inserted between a cooling system (5) and the surface layer (8) of the target (1), it being possible for a heating system (4) to be optionally incorporated between the surface layer (8) and the heat-transfer regulating system (6).

10. Apparatus according to Claim 9, characterized in that it comprises a retaining tank (2) for the target (1), the bottom (3) of which is made of a thermally conductive material, in which bottom the optional heating system (4), the cooling system (5) and the regulating system (6) are incorporated in the form of superposed layers.

11. Apparatus according to Claim 10, characterized in that the optional heating system (4) is located near the target (1).

12. Apparatus according to any one of Claims 9 to 11, characterized in that the heat-transfer regulating system (6) comprises a circuit for a liquid metal, more particularly gallium, means being provided for removing this metal from this circuit when a heat influx is necessary and for introducing this metal into this circuit when heat has to be removed from the target (1).

13. Apparatus according to any one of Claims 9 to 12, characterized in that it comprises two probes (S₁ and S₂) for measuring the level of the liquid layer (8) of the target (1), one (S₁) for the maximum level and the other (S₂) for the minimum level, each of these probes operating preferably by comparing the measured voltage with the voltage at the target (1).

14. Apparatus according to any one of Claims 9 to 13, characterized in that it comprises a mechanism (12) for supplying sputtering metal to the surface layer (8) of the target (1) when the thickness of the latter falls below a predetermined limit.

15. Apparatus according to either of Claims 13 and 14, characterized in that it comprises a probe (S₃) for measuring and controlling the temperature (Tₘ) of the surface layer (8) of the target (1), this probe (S₃) being used to act on the heat-transfer regulating system (6) and to bring the temperature (Tₘ) of the abovementioned surface layer (8) of the target (1) above its melting point when the target is being supplied with metal to be melted.

16. Apparatus according to any one of Claims 9 to 15, characterized in that the substrate (17) is in the form of a continuous strip moving through at least one chamber (15, 16) in which a target (1) is placed.

17. Apparatus according to Claim 16, characterized in that it comprises two successive chambers (15) and (16) for the purpose of coating both sides of the aforementioned strip (17), the target (1) being arranged in one of the chambers (15) on one side of the strip (17) and in the other chamber (16) on the opposite side of this strip.
